# EUROPÄISCHE PATENTSCHRIFT

(11) **EP 2 629 912 B1**
(45) Veröffentlichungstag und Bekanntmachung des Hinweises auf die Patenterteilung: **22.07.2020**
(21) Anmeldenummer: 11764517.6
(22) Anmeldetag: 23.09.2011
(51) Int. Cl.: B22F 1/02

(54) **AUSGANGSWERKSTOFF EINER SINTERVERBINDUNG UND VERFAHREN ZUR HERSTELLUNG DER SINTERVERBINDUNG**
STARTER MATERIAL FOR A SINTERING COMPOUND AND METHOD FOR PRODUCING SAID SINTERING COMPOUND
MATÉRIAU DE DÉPART D'UN ASSEMBLAGE PAR FRITTAGE ET PROCÉDÉ DE RÉALISATION D'UN ASSEMBLAGE PAR FRITTAGE

(30) Priorität: 20.10.2010 DE 102010042702
(43) Veröffentlichungstag der Anmeldung: 28.08.2013
(60) Teilanmeldung: 20161131.6
(73) Patentinhaber: Robert Bosch GmbH, 70442 Stuttgart (DE)
(72) Erfinder: WOLDE-GIORGIS, Daniel, 70771 Leinfelden-Echterdingen (DE); FEIOCK, Andrea, 72124 Pliezhausen (DE)
(86) Internationale Anmeldenummer: PCT/EP2011/066613
(87) Internationale Veröffentlichungsnummer: WO 2012/052251

(56) Entgegenhaltungen:
- EP-A1- 1 716 947
- EP-A1- 1 749 600
- EP-A1- 1 950 767
- WO-A1-2009/122467
- WO-A1-2010/081752
- US-A1- 2008 173 398

## Beschreibung

Die Erfindung betrifft einen Ausgangswerkstoff für eine Sinterverbindung, ein Verfahren zu deren Ausbildung sowie die Verwendung des Ausgangswerkstoffes.

### Stand der Technik

Leistungselektronik wird in vielen Bereichen der Technik eingesetzt. Gerade in elektrischen oder elektronischen Geräten, in welchen große Ströme fließen, ist der Einsatz von Leistungselektronik unumgänglich. Die in der Leistungselektronik notwendigen Stromstärken führen zu einer Eigenerwärmung der enthaltenen elektrischen oder elektronischen Komponenten. Eine weitere thermische Belastung ist gegeben durch den Einsatz derartiger elektrischer oder elektronischer Geräte an Betriebsorten mit gegenüber der Raumtemperatur deutlich erhöhter Temperatur. Als Beispiele sind Steuergeräte im Automobilbereich zu nennen, die unmittelbar im Motorraum angeordnet sind. Dabei ist das Steuergerät zusätzlich einem ständigen Temperaturwechsel ausgesetzt, wodurch die enthaltenen elektrischen und/oder elektronischen Komponenten stark thermisch belastet werden. Im Allgemeinen sind Temperaturwechsel in einem Bereich bis zu einer Temperatur von 200 Grad Celsius üblich. Es werden jedoch zunehmend auch darüber hinaus gehende Einsatztemperaturen gefordert. Dadurch werden insgesamt erhöhte Anforderungen an die Zuverlässigkeit und die Funktionssicherheit von elektrischen oder elektronischen Geräten mit Leistungselektronik gestellt.

Üblicherweise erfolgt eine Anbindung von elektrischen oder elektronischen Komponenten - beispielsweise auf ein Trägersubstrat - durch eine Verbindungsschicht. Als eine derartige Verbindungsschicht sind Lotverbindungen, beispielsweise aus Zinn-Silber oder Zinn-Silber-Kupfer, bekannt. Bei höheren Einsatztemperaturen sind bleihaltige Lotverbindungen einsetzbar. Bleihaltige Lotverbindungen sind jedoch durch gesetzliche Bestimmungen aus Gründen des Umweltschutzes hinsichtlich ihrer zulässigen technischen Anwendungen stark beschränkt. Alternativ bieten sich für den Einsatz bei erhöhten bzw. hohen Temperaturen, insbesondere über 200 Grad Celsius, bleifreie Hartlote an. Bleifreie Hartlote weisen in der Regel einen höheren Schmelzpunkt als 200°C auf. Problematisch daran ist, dass bei der Verwendung von Hartlot zur Ausbildung einer Verbindungsschicht nur wenige elektrische oder elektronische Komponenten als Fügepartner in Frage kommen, die den hohen Temperaturen beim Schmelzen der Hartlote standhalten können.

Eingesetzt werden auch Sinterverbindungen, die bereits bei niedrigen Temperaturen verarbeitet werden können und die dennoch für einen Betrieb bei erhöhten Temperaturen geeignet sind. So zeigt die Patentanmeldung DE102007046901 A1 derartige Sinterverbindungen. Zur Herstellung einer Sinterverbindung wird ein pastenförmiger Ausgangswerkstoff umfassend leicht zersetzbare Silberverbindungen sowie Silberflocken oder Nanosilber verwendet. Weiterhin kann im Ausgangswerkstoff beispielsweise Kupfer enthalten sein. Zur Ausbildung der Pastenform werden Lösungsmittel beigemischt. Bei einer Temperaturbehandlung des Ausgangswerkstoffs unter 300°C zersetzen sich die Silberverbindungen unter Ausbildung des elementaren Silbers und bilden zusammen mit den Silberflocken und dem Nanosilber die Sinterverbindung aus. Die Sinterverbindung wird eingesetzt zum Kontaktieren zweier Elemente. Die Kontaktierung kann bei einer Verwendung des beschriebenen Ausgangswerkstoffes bereits bei niedrigen Anpressdrücken der Kontaktierungspartner erfolgen.

Die DE 60221433 T2 offenbart eine Sinterverbindung, die aus einer Paste hergestellt wird, welche Partikel aus einer Silberverbindung enthält. Neben den Partikeln aus der Silberverbindung ist auch ein Reduktionsmittel in gelöster Form enthalten. Bei einer Temperaturbehandlung der Sinterpaste unterhalb von 200°C wird die Silberverbindung zum elementaren Silber reduziert unter Bildung der Sinterverbindung.

Die US6951666 zeigt die Herstellung unterschiedlicher Sinterverbindungen. Dabei werden allgemeine Kombinationsmöglichkeiten verschiedener Ausgangselemente beschrieben. Als Ausgangselemente sind unter Anderem molekulare Metalle, zahlreiche metallische Partikel in Nano- oder Mikrogröße, Beschichtungen, Lösungsmittel, Additive, reduzierende Mittel, Kristallisationshemmer, Benetzungsmittel und weitere genannt.

Aus der Offenlegungsschrift WO2009/122467 A1 ist eine Pastenzusammensetzung zur Verbindung von metallischen Komponenten offenbart, bei welcher Metallpartikel mit einer organischen, wasserabweisenden, nicht-Amin-basierten Beschichtung versehen sind.

In der Offenlegungsschrift EP1716947 A1 wird die Herstellung von metallischen Nanopartikeln beschrieben, die eine Sinterverbindung bei niedrigen Temperaturen ermöglicht. Mittels eines chemischen Prozesses werden Ausgangsmaterialien innerhalb einer Myristylalkohollösung zu Partikeln mit einem metallischen Kern und einer physisch an den Kern angebundenen organischen Beschichtung gewandelt.

Die Offenlegungsschrift US20080173398 A1 zeigt ein Verbindungsmaterial aus mit einer organischen Substanz beschichteten Metallpartikel unterschiedlicher Größe.

### Offenbarung der Erfindung

### Vorteile

Der Erfindung liegt die Aufgabe zu Grunde, einen Ausgangswerkstoff für eine Sinterverbindung bereitzustellen, mit welchem in einfacher Weise eine Sinterverbindung bei niedrigen Verarbeitungstemperaturen und -drücken hergestellt werden kann.

Diese Aufgabe wird durch einen Ausgangswerkstoff für eine Sinterverbindung und ein Verfahren zu deren Herstellung mit den Merkmalen der unabhängigen Ansprüche 1, 9 und 10 gelöst.

Das Silbercarbonat, das Silberlactat, das Silberstearat oder das Natriumcarbonat wird nachfolgend als die erfindungsgemäße Metallverbindung bezeichnete. Die erfindungsgemäß vorgesehene Beschichtung umschließt dabei in vorteilhafter Weise die Partikel vollständig, zumindest jedoch nahezu vollständig. Dadurch wirkt die Beschichtung wie ein Schutzmantel mittels welchem sichergestellt werden kann, dass die Partikel, insbesondere der Anteil an Metallverbindungen und/oder Edelmetalloxiden in den Partikeln, chemisch unverändert bleiben. Somit sind die Partikel bzw. der Ausgangswerkstoff umfassend die Partikel bis zur Herstellung einer Sinterverbindung lagerungsfähig.

Durch das Vorsehen eines Reduktionsmittels in einer Beschichtung der Partikel ist das Reduktionsmittel nächstmöglich zu den Partikeln, insbesondere auch zu deren Anteil an der erfindungsgemäßen Metallverbindung und/oder dem Edelmetalloxid, als Reduktionspartner positioniert. Dadurch erfolgt der Reduktionsprozess besonders optimiert. Zum einen ist eine sehr schnelle Umwandlung der erfindungsgemäßen Metallverbindung und/oder des Edelmetalloxids zu dem zugrunde liegenden elementaren Metall bzw. Edelmetall die Folge. Zum anderen ist das Reduktionsmittel durch Aufbringen als Beschichtung sehr gleichmäßig und fein verteilt. Dies betrifft sowohl die Verteilung des Reduktionsmittels auf einem Partikel selbst, als auch in dem die Partikel enthaltendem Ausgangswerkstoff insgesamt. Der Reduktionsprozess erfolgt somit über alle Partikel hinweg gleichzeitig und einheitlich. Daraus resultiert der Vorteil, dass eine aus dem erfindungsgemäßen Ausgangswerkstoff hergestellte Sinterverbindung ein sehr homogenes Sintergefüge aufweist.

Ferner ist besonders vorteilhaft, dass auf diese Weise zusätzlich Bedingungen vorliegen, die bei einer ausreichenden Menge an Reduktionsmittel zu einer Umwandlung nahezu des gesamten - bevorzugt des gesamten - im Ausgangswerkstoff vorliegenden Anteils der erfindungsgemäßen Metallverbindung und/oder dem Edelmetalloxid zu dem elementaren Metall bzw. Edelmetall führen. In günstiger Weise ergibt sich dann eine besonders hohe thermische und/oder elektrische Leitfähigkeit der aus dem erfindungsgemäßen Ausgangswerkstoff hergestellten Sinterverbindungen.

Durch die in den abhängigen Ansprüchen aufgeführten Maßnahmen sind vorteilhafte Weiterbildungen und Verbesserungen des im unabhängigen Anspruch angegebenen Ausgangswerkstoffs möglich.

In einer ersten Ausführungsform bestehen die Partikel im erfindungsgemäßen Ausgangswerkstoff vollständig aus dem Silbercarbonat, dem Silberlactat, dem Silberstearat oder dem Natriumcarbonat oder vollständig aus dem Edelmetalloxid. Alternativ ist der Ausgangswerkstoff als Mischung von Partikeln aus einer erfindungsgemäßen Metallverbindung und Partikeln aus einem Edelmetalloxid vorgesehen. Zusätzlich können sich die im Ausgangswerkstoff vorgesehenen Partikel, die aus einer erfindungsgemäßen Metallverbindung bestehen, untereinander darin unterscheiden, dass für diese zumindest zwei unterschiedlichen erfindungsgemäßen Metallverbindungen vorgesehen werden. Das Gleiche gilt auch für die im Ausgangswerkstoff vorgesehenen Partikel, die aus einem Edelmetalloxid bestehen - es sind dann Partikel mit einem ersten Edelmetalloxid und Partikel mit zumindest einem zweiten Edelmetalloxid vorgesehen. Insgesamt ist vorteilhaft, dass die für den Ausgangswerkstoff vorgesehenen Partikel auch als frei verkäufliche Standardpartikel zu beziehen sind und somit sehr kostengünstig sind.

Anders als die Erfindung können auch derartig andere Partikel vorgesehen werden, die sowohl anteilig eine organische Metallverbindung als auch anteilig ein Edelmetalloxid enthalten. Derartige andere Partikel lassen sich beispielsweise durch Verpressen oder Vermahlen von Ausgangspartikeln aus einer organischen Metallverbindung und Ausgangspartikel aus einem Edelmetalloxid herstellen. Es bestehen noch weitere chemische oder physikalische Herstellungsmöglichkeiten für derartige andere Partikel, welche aus der technischen Literatur zur Partikelherstellung entnommen werden können. Gleichsam zeigen sich derartig andere Partikel ferner darin, dass diese einen metallischen Kern aufweisen, der mit einer äußeren Schicht versehen ist. Dabei ist die äußere Schicht als Beschichtung des metallischen Kerns aus einer organischen Metallverbindung und/oder einem Edelmetalloxid ausgeführt. So kann dann die Beschichtung aus der organischen Metallverbindung bzw. Edelmetalloxid die gleiche metallische Basis aufweisen wie der metallische Kern. Ebenso denkbar ist jedoch auch, dass sich die metallische Basis der Beschichtung aus organischer Metallverbindung bzw. Edelmetalloxid vom Werkstoff des metallischen Kerns unterscheidet. Ferner besteht eine vorteilhafte Möglichkeit, im Ausgangswerkstoff unterschiedliche Varianten dieser derartig anderen Partikel einzusetzen. Die Varianten ergeben sich in Bezug auf unterschiedliche metallische Kerne und/oder auf unterschiedliche auf die metallischen Kerne aufgetragene Beschichtungen. So können beispielsweise derartige andere Partikel mit einem Kern aus einem ersten Metall und derartige andere Partikel mit einem Kern zumindest eines zweiten Metalls im Ausgangswerkstoff vorliegen. Weiter können auch derartige andere Partikel mit einem metallischen Kern und einer auf diesem aufgetragenen Beschichtung aus einer ersten organischen Metallverbindung und/oder einem ersten Edelmetalloxid und derartige andere Partikel mit einem metallischen Kern und einer auf diesem aufgetragenen Beschichtung aus zumindest einer zweiten organischen Metallverbindung und/oder einem zweiten Edelmetalloxid vorgesehen werden. Ferner kann dann bei dieser Ausführungsform der metallische Kern der derartigen anderen Partikel aus Kupfer oder einem Edelmetall ausgeführt sein. Der metallische Kern kann hierbei auch aus Silber, Gold, Platin und/oder Palladium sein. Ferner kann man einen derart ausgeführten Kern der derartig anderen Partikel mit einer Beschichtung aus Silber oder Silberoxid versehen. Derartige Beschichtungen aus Silber oder Silberoxid erleichtern ein Aufbringen einer weiteren Beschichtung, die ein Reduktionsmittel enthält, z.B. eine Fettsäure. Alternativ kann ein derart aus Silber ausgeführter Kern der derartig anderen Partikel auch mit einer Beschichtung aus Natriumcarbonat versehen werden, die ihrerseits mit einer weiteren reduktionsmittelhaltigen Beschichtung versehen wird. In diesem Falle bildet sich im Rahmen einer Temperaturbehandlung des Ausgangswerkstoffes eine Silber-Natriumlegierung aus. Diese weist einen gegenüber Silber verringerten Schmelzpunkt auf. Dadurch wird ein stoffschlüssiger Kontakt aller im Ausgangswerkstoff enthaltenen Partikel unterstützt und es werden während des Sinterprozesses ablaufende Diffusionsvorgänge begünstigt. Es kann noch ausgesagt werden, dass bei dieser Ausführungsform der derartig anderen Partikel mit einem metallischen Kern der metallische Kern einen großen Anteil am Volumen einnehmen kann, während hingegen die Beschichtung mit einer insbesondere kleinen Beschichtungsschichtdicke einen verhältnismäßig geringen Mengenanteil an den derartig anderen Partikeln ausmachen kann. Die Beschichtung aus der organischen Metallverbindung und/oder dem Edelmetalloxid verkapselt dabei den metallischen Kern. Dadurch ist sichergestellt, dass der metallische Kern vor chemischen Reaktionsprozessen geschützt ist. Somit bleiben die derartig anderen Partikel, insbesondere der metallische Kern der derartig anderen Partikel, im Ausgangswerkstoff bis zur Ausbildung einer Sinterverbindung unter Temperatureinfluss chemisch stabil.
Ferner erfolgt der im Rahmen einer Temperaturbehandlung eintretende Reduktionsprozess, bei welchem die organische Metallverbindung und/oder das Edelmetalloxid zu dem zugrunde liegenden elementaren Metall und/oder Edelmetall reduziert werden, bei dieser Ausführungsform der derartig anderen Partikel mit einem metallischen Kern besonders schnell. Dies beruht darauf, dass sich der Reduktionsprozess auf die auf den metallischen Kern aufgetragene Beschichtung aus einer organischen Metallverbindung bzw. Edelmetalloxide beschränkt. Durch die geringe Schichtdicke der Beschichtung ist zusätzlich sichergestellt, dass der gesamte im Ausgangswerkstoff vorliegende Anteil an organischer Metallverbindung und/oder Edelmetalloxid zu dem elementaren Metall und/oder dem Edelmetalloxid umgewandelt wird. Ferner fallen bei dieser Ausführungsform auch nur geringe Mengen an gasförmigen Nebenprodukten infolge des Reduktionsprozesses an.

Grundsätzlich umfasst die Erfindung, dass die auf die Partikel aufgetragene reduktionsmittelhaltige Beschichtung mindestens ein Reduktionsmittelwelches mindestens einen Alkohol aus der Gruppe der primären oder sekundären Alkohole und/oder ein Amin und/oder Ameisensäure enthält. Ferner ist es besonders vorteilhaft, wenn das Reduktionsmittel eine Fettsäure, insbesondere eine Isostearinsäure, eine Stearinsäure, eine Ölsäure, eine Laurinsäure, oder eine Mischung verschiedener Fettsäuren enthält. Die erfindungsgemäß vorgesehene Beschichtung, die ein Reduktionsmittel enthält, kann auch ausschließlich durch das Reduktionsmittel selbst, insbesondere durch die zuvor genannten Reduktionsmittel, gebildet sein.

Insgesamt lassen sich derartige Beschichtungen in einfacher Weise auf den für den Ausgangswerkstoff vorgesehenen Partikeln aufbringen. Zusätzlich zeigen die genannten Reduktionsmittel im Rahmen einer Temperaturbehandlung des Ausgangswerkstoffes zur Ausbildung einer Sinterverbindung ein besonders gutes Reduktionsverhalten gegenüber der im organischen Ausgangswerkstoff zumindest anteilig enthaltenen erfindungsgemäßen Metallverbindungen bzw. Edelmetalloxide.

Grundsätzlich wandeln sich die erfindungsgemäßen Metallverbindungen oder Edelmetalloxide bei hohen Temperaturen in das zugrunde liegende elementare Metall oder Edelmetall um. Unter Einsatz einer reduktionsmittelhaltigen Beschichtung erfolgt die Umwandlung der erfindungsgemäßen Metallverbindung und/oder des Edelmetalloxids zum elementaren Metall und/oder Edelmetall in vorteilhafter Weise bereits bei niedrigen Verarbeitungstemperaturen. Insbesondere bildet sich das elementare Metall und/oder Edelmetall bei einer Temperaturbehandlung des Ausgangswerkstoffes unterhalb der Sintertemperatur des elementaren Metalls und/oder Edelmetalls aus. Dadurch ist es möglich, dass in vorteilhafter Weise über die ausgebildete Sinterverbindung verbundene Fügepartner, beispielsweise elektrische und/oder elektronische Komponenten einer elektronischen Schaltung, keinen hohen Temperaturen während der Ausbildung der Sinterverbindung ausgesetzt werden. Somit können temperaturempfindliche elektrische und/oder elektronische Komponenten in elektronischen Schaltungen elektrisch und/oder thermisch kontaktiert werden, die auf Grund der sonst üblichen zu hohen Prozesstemperaturen bei der Verbindungsherstellung nicht eingesetzt werden konnten.

Insgesamt zeigt der erfindungsgemäße Ausgangswerkstoff durch die Maßnahmen in den genannten Ausführungsformen und Weiterbildungen eine sehr hohe Umwandlungsquote von bis zu 99 % und mehr der enthaltenen erfindungsgemäßen Metallverbindungen und/oder Edelmetalloxiden zu dem elementaren Metall und/oder Edelmetall. Eine zumindest nahezu vollständige Umwandlung kann insbesondere dann erreicht werden, wenn der Anteil aus erfindungsgemäßen Metallverbindung und/oder Edelmetalloxid zum Anteil des Reduktionsmittels in der reduktionshaltigen Beschichtung in einem im Wesentlichen stöchiometrischen Verhältnis vorliegt. Nicht umgewandelte Anteile, die ansonsten in der Sinterverbindung aufgrund eines zu geringen Reduktionsmittelanteils verbleiben können, können die elektrische Leitfähigkeit der Sinterverbindung verringern.
Da auf Grund des stöchiometrischen Verhältnisses ein Überschuss an Reduktionsmittel ausgeschlossen ist, kann die Ausbildung einer Sinterverbindung aus dem Ausgangswerkstoff alternativ in einem Vakuum oder in einer Schutzgasatmosphäre ausgeführt werden. Liegt dagegen ein Überschuss an Reduktionsmittel vor, so wird eine Sauerstoffzufuhr, z.B. in Form einer Luftzufuhr, benötigt, um diese vollständig auszubrennen.

In Weiterbildung des erfindungsgemäßen Ausgangswerkstoffes sind in vorteilhafter Weise zusätzlich weitere Partikel, enthaltend ein Element der vierten Hauptgruppe des Periodensystems, vorgesehen. Diese weiteren Partikel können dazu beitragen, vorteilhafte Eigenschaften bei der aus dem Ausgangswerkstoff gebildeten Sinterverbindung einzustellen.

Eine erste Möglichkeit ist gegeben, dem Ausgangswerkstoff bevorzugt weitere Partikel aus Silizium beizumischen. Silizium setzt man beispielsweise als Füllstoff dem Ausgangswerkstoff zu, wodurch der thermische Ausdehnungskoeffizient einer aus dem Ausgangswerkstoff gebildeten Sinterverbindung gesenkt wird. Zusätzlich weist Silizium eine hohe elektrische Leitfähigkeit auf. Partikel aus Silizium werden dem Ausgangswerkstoff darüber hinaus auch als kostengünstige Werkstoffalternative zu Silber bzw. zu Silberverbindungen zugesetzt. Dadurch kann der Anteil an Silber im Ausgangswerkstoff gering gehalten werden. Grundsätzlich verhalten sich Partikel aus Silizium während einer Temperaturbehandlung des Ausgangswerkstoffes zur Ausbildung einer Sinterverbindung in vorteilhafter Weise inert. Somit liegen Partikel aus Silizium bei einer gebildeten Sinterverbindung in unveränderter Form innerhalb einer Matrix der gebildeten Umwandlungsprodukte aus Metall und/oder Edelmetall vor.

Eine andere Möglichkeit ist gegeben, ebenso bevorzugt weitere Partikel aus Zinn und Blei dem Ausgangswerkstoff zuzugeben. Zinn und Blei bilden bei einer Temperaturbehandlung des Ausgangswerkstoffes Legierungen mit den Umwandlungsprodukten aus Metall und/oder Edelmetall aus, die aufgrund des stattfindenden Reduktionsprozesses entstehen. Diese Legierungen weisen einen gegenüber dem Metall und/oder Edelmetall geringeren Schmelzpunkt auf, wodurch die Verarbeitungstemperatur zur Ausbildung der Sinterverbindung weiter gesenkt werden kann. Ferner liegen die Legierungen dann als duktile Phasen innerhalb des gebildeten Sintergefüges vor, wodurch die gebildeten Sinterverbindungen weniger anfällig gegenüber thermischen und/oder mechanischen Belastungen, insbesondere wechselnden Belastungen sind. Ferner weist beispielsweise Zinn einen niedrigen Schmelzpunkt auf, sodass bei einer Temperaturbehandlung des Ausgangswerkstoffes die Partikel aus Zinn frühzeitig aufschmelzen und einen stoffschlüssigen Kontakt aller im Ausgangswerkstoff enthaltenen Partikel bewirken. Dies begünstigt in vorteilhafter Weise die während des Sinterprozesses ablaufenden Diffusionsvorgänge.

Eine zusätzliche Möglichkeit ist gegeben, die weiteren Partikel ebenso bevorzugt aus einem Edelmetall, beispielsweise aus Silber, auszuführen. Diese weisen bereits eine hohe thermische und/oder elektrische Leitfähigkeit auf.

In Weiterbildung der Erfindung weisen die weiteren Partikel zusätzlich eine Beschichtung auf. Eine Beschichtung, beispielsweise aus einem Edelmetall, verbessert insgesamt das Versintern der weiteren Partikel innerhalb des Sintergefüges einer aus dem Ausgangswerkstoff gebildeten Sinterverbindung. So werden beispielsweise weitere Partikel aus Silizium bevorzugt mit Silber und/oder Gold beschichtet. Bevorzugt werden bei weiteren Partikeln aus einem Edelmetall diese mit einer zusätzlichen Beschichtung versehen, die ein Reduktionsmittel enthält, insbesondere eine Fettsäure. Derartig beschichtete weitere Partikel aus einem Edelmetall, insbesondere aus Silber, begünstigen zusätzlich die Reduktion der zumindest anteilig im Ausgangswerkstoff enthaltenen organischen Metallverbindung und/oder des Edelmetalloxids zu dem elementaren Metall und/oder Edelmetall.

Grundsätzlich von Vorteil ist es, wenn die im Ausgangswerkstoff enthaltenen Partikel eine mittlere Korngröße von 0,01 - 50 µm, besonders bevorzugt von 0,1 - 10 µm, aufweisen. Infolge der größeren spezifischen Oberfläche ist eine erhöhte Reaktionsfähigkeit dieser Partikel gegeben. Dadurch kann die notwendige Verarbeitungstemperatur und die Prozesszeit zur Ausbildung einer Sinterverbindung gering gehalten werden.

Des Weiteren sind die Partikel bevorzugt sphärisch und/oder plättchenförmig ausgebildet. Eine Mischung derartiger Partikelgeometrien ggf. zusammen mit rundförmigen Partikeln ermöglicht eine hohe Dichte der aus dem Ausgangswerkstoff gebildeten Sinterverbindung.

Der Ausgangswerkstoff wird vorzugsweise als Paste bereitgestellt. Die Viskosität der Paste ist dabei maßgeblich durch das beigemischte Lösungsmittel. einstellbar. Ebenso ist es von Vorteil, den Ausgangswerkstoff in Form einer Tablette oder als Formkörper, insbesondere als ein flacher Formkörper, bereitzustellen. In diesem Fall wird der pastenförmige Ausgangswerkstoff in eine Form gegeben oder auf eine Folie aufgetragen. Anschließend wird das Lösungsmittel mittels einer Temperaturbehandlung aus dem Ausgangswerkstoff ausgetrieben. Hier ist ein Lösungsmittel vorzusehen, welches bereits bei einer Temperatur, die unterhalb der eigentlichen Sintertemperatur des Ausgangswerkstoffs liegt, rückstandsfrei ausgetrieben werden kann. Der auf diese Weise gebildete Ausgangswerkstoff kann auch als Großnutzen gefertigt werden, welcher dann zu kleinen anwendungsspezifischen Formkörpern geschnitten wird.

Grundsätzlich kann die Beschichtung von im Ausgangswerkstoff enthaltenen Partikeln mit Hilfe bekannter Beschichtungsverfahren ausgeführt werden. Diese können aus bekannter technischer Literatur entnommen werden. Beispielhaft sind hierbei chemische und physikalische Beschichtungsverfahren zu nennen, wie zum Beispiel eine chemische bzw. physikalische Gasphasenabscheidung.

Bisherige Versuche zeigen, dass die aus dem erfindungsgemäßen Ausgangswerkstoff gebildete Sinterverbindung die elektrische Leitfähigkeit von reinem Silber erreichen kann, zumindest aber einen Wert der elektrischen Leitfähigkeit aufweist, der nur gering unter dem von reinem Silber liegt. Zusätzlich weist die gebildete Sinterverbindung eine thermische Leitfähigkeit von >100 W/mK auf.

Die Erfindung betrifft weiterhin auch ein Verfahren zur Ausbildung einer thermisch und/oder elektrisch leitenden Sinterverbindung. Ausgegangen wird hierbei von einem Ausgangswerkstoff der vorbeschriebenen Art, der zwischen zwei Fügepartner gebracht wird. Bevorzugte Fügepartner sind elektrische und/oder elektronische Komponenten mit Kontaktstellen, die in unmittelbaren physischen Kontakt mit dem Ausgangswerkstoff gebracht werden. Hierbei kann der Ausgangswerkstoff in Form einer Druckpaste beispielsweise mittels Sieb- oder Schablonendruck auf die Kontaktstellen aufgetragen werden. Ebenso ist der Auftrag durch Injekt- oder Dispensverfahren möglich. Eine sehr einfache Möglichkeit besteht weiterhin darin, den Ausgangswerkstoff als Formkörper zwischen den Fügepartner anzuordnen.

Anschließend wird die Sinterverbindung durch eine Temperaturbehandlung des Ausgangswerkstoffes ausgebildet. Unter Zufuhr von Wärme reagiert die im Ausgangswerkstoff zumindest anteilig enthaltende erfindungsgemäße Metallverbindung bzw. das Edelmetalloxid mit dem in der Beschichtung enthaltenen Reduktionsmittel. Dabei handelt es sich um einen Reduktionsprozess, bei welchem die erfindungsgemäße Metallverbindung und/oder das Edelmetalloxid zu dem zugrundeliegenden elementaren Metall und/oder Edelmetall reduziert werden.

Der Reduktionsprozess beginnt dabei in vorteilhafter Weise bereits unterhalb der Sintertemperatur des elementaren Metalls und/oder Edelmetalls. Es wird daher eine Verarbeitungstemperatur von < 400°C vorgesehen, bevorzugt von < 300°C, insbesondere von < 250°C. Ggf. wird zur Verbesserung des Sintervorgangs dieser unter Druck ausgeführt. Als Prozessdruck wird ein Druck < 4MPa vorgesehen, bevorzugt < 1,6 MPa, besonders bevorzugt < 0,8 MPa. Überschüssiges Reduktionsmittel wird unter der Voraussetzung einer ausreichenden Sauerstoffzufuhr vollkommen ausgebrannt, beispielsweise unter Luftatmosphäre. Bevorzugt sind Fügepartner mit Kontaktstellen aus einem Edelmetall vorgesehen, beispielsweise aus Gold, Silber oder einer Legierung aus Gold oder Silber.

Bei einer alternativen Möglichkeit des erfindungsgemäßen Verfahrens wird die Sinterverbindung im Vakuum und/oder unter einer Stickstoffatmosphäre ausgebildet. Da in diesem Fall überschüssiges Reduktionsmittel nicht verbrannt werden kann, ist ein Ausgangswerkstoff vorzusehen, bei welchem der Anteil der erfindungsgemäßen Metallverbindung und/oder des Edelmetalloxids zum Anteil des Reduktionsmittels in der Beschichtung enthaltend ein Reduktionsmittel in einem stöchiometrischen Verhältnis vorliegt. Während der Temperaturbehandlung wird das enthaltene Reduktionsmittel demzufolge vollkommen aufgebraucht. Zusätzlich ist die organische Metallverbindung und/oder das Edelmetalloxid vollständig in das elementare Metall und/oder Edelmetall umgewandelt. In vorteilhafter Weise können bei dieser Verfahrensalternative auch Fügepartner mit einer nicht edelmetallhaltigen Kontaktstelle vorgesehen werden, die beispielsweise aus Kupfer ausgebildet ist. Somit können auch kostengünstige elektrische und oder elektronische Komponenten herangezogen werden. Ferner sind durch Wegfall eines ansonsten notwendigen Prozessdruckes die vorgesehenen elektrischen und/oder elektronischen Komponenten keinen mechanischen Belastungen ausgesetzt.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a: schematisch Partikel eines Ausgangswerkstoffs einer Sinterverbindung,
- Fig. 1b: schematisch eine Ausführungsform von Partikeln eines erfindungsgemäßen Ausgangswerkstoffs einer Sinterverbindung gemäß einer möglichen Ausführungsform,
- Fig. 2a: schematisch eine Mischung von Partikeln in einem Ausgangswerkstoff mit Partikeln entsprechend der Fig. 1a und Partikeln aus Silizium
- Fig. 2b: schematisch eine alternative Mischung von Partikel entsprechend der Fig. 1a und Partikeln aus Zinn,
- Fig. 2c: schematisch eine weitere Mischung von Partikeln eines erfindungsgemäßen Ausgangswerkstoffs mit Partikeln entsprechend der Fig. lb und weiteren Partikeln aus Silber,
- Fig. 3: schematisch eine Schnittdarstellung eines Sinterofens und einer im Sinterofen angeordneten elektronischen Schaltung, wobei die elektronische Schaltung zwischen einem Chip und einem Substrat einen erfindungsgemäßen Ausgangswerkstoff aufweist.

### Ausführungsformen der Erfindung

In den Figuren sind gleiche Bauteile und Bauteile mit der gleichen Funktion mit den gleichen Bezugszeichen gekennzeichnet.

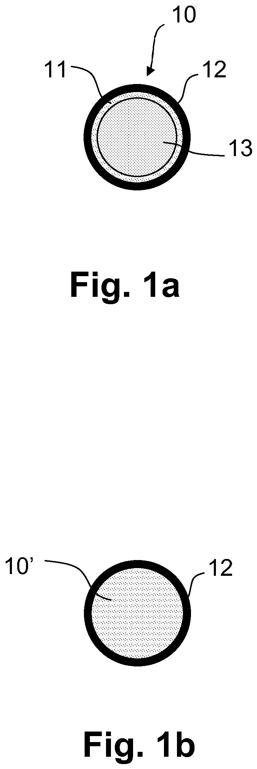

Anders als die Erfindung sind in Fig. 1a schematisch die bereits zuvor genannten derartig anderen Partikel 10 gezeigt. Die derartig anderen Partikel 10 weisen einen metallischen Kern 13 aus Silber auf, auf welchem eine den metallischen Kern vorzugsweise vollständig umschließende dünne erste Beschichtung 11 aufgetragen ist. Diese erste Beschichtung 11 enthält zumindest anteilig eine organische Metallverbindung und/oder ein Edelmetalloxid. Im konkreten Beispiel enthält die erste Beschichtung 11 Ag₂CO₃, Ag₂O und/oder AgO. Auf die Partikel 10 ist eine zweite Beschichtung 12 aufgetragen, welche eine Fettsäure als Reduktionsmittel enthält. Somit grenzt die zweite reduktionsmittelhaltige Beschichtung 12 unmittelbar an die erste Beschichtung 11 an und umschließt diese beispielsweise vollständig. Der Anteil der Fettsäure in der zweiten Beschichtung 12 ist derart gewählt, dass die Fettsäure in einem stöchiometrischen Verhältnis zu dem Anteil der in Form der ersten Beschichtung 11 in den Partikel 10 enthaltenen organischen Metallverbindung 11 aus Ag₂CO3, Ag₂O und/oder AgO vorliegt.

Die Fig. 1b zeigt schematisch eine Ausführungsform an Partikeln eines erfindungsgemäßen Ausgangswerkstoffs. Im Unterschied zu derartig anderen Partikel 10 aus Fig. 1a sind die Partikel 10' im Wesentlichen vollständig aus Ag₂CO₃, Ag₂O und/oder AgO gebildet.

Ein erfindungsgemäßer Ausgangswerkstoff kann optional neben den Partikel 10' entsprechend der Fig. 1b zusätzlich weitere Partikel enthalten.

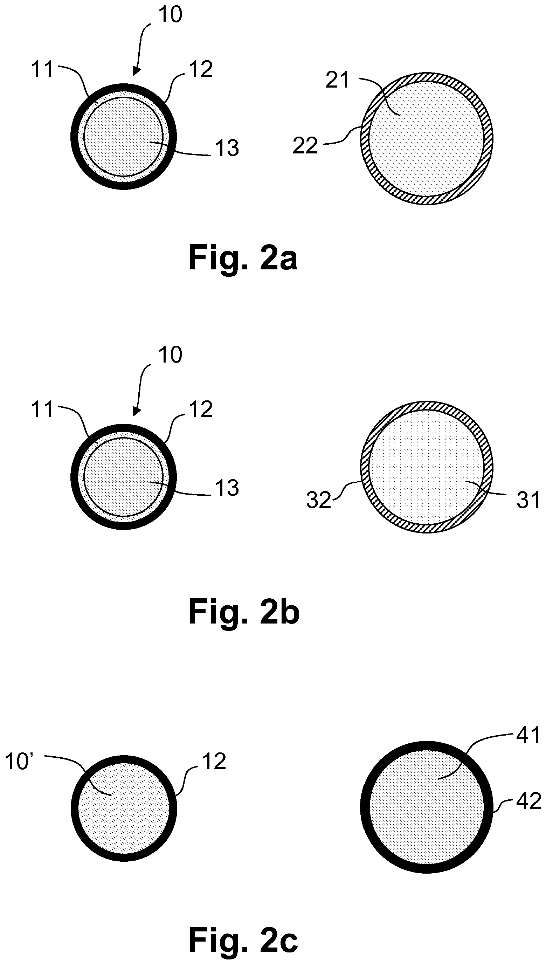

Die Fig. 2a zeigt eine Mischung von Partikeln, welche Partikel 10 entsprechend der Fig. la und weitere Partikel 21 aus Silizium aufweist. Die weiteren Partikel 21 aus Silizium weisen eine zusätzliche Beschichtung 22 aus einer Silberverbindung auf.

Die Fig. 2b zeigt schematisch eine zur Mischung von Partikeln gemäß Fig. 2a alternative Mischung, bei welcher anstelle der weiteren Partikel 21 aus Silizium weitere Partikel 31 aus Zinn vorgesehen sind, die eine Beschichtung 32 aus einer Silberverbindung aufweisen.

Die Fig. 2c zeigt schematisch eine in einem erfindungsgemäßen Ausgangswerkstoff bevorzugt vorgesehene Mischung von Partikeln. Hierbei liegen Partikel 10' entsprechend der Fig. 1b und zusätzlich weitere Partikel 41 aus Silber als Mischung vor. Ferner ist auf den weiteren Partikeln 41 aus Silber eine zusätzliche Beschichtung 42 aus einer Fettsäure aufgetragen.

Die in dem erfindungsgemäßen Ausgangswerkstoff enthaltenen Partikel 10', 21, 31, 41 weisen eine Partikelgröße zwischen 0,1 - 10 µm auf. Die Partikel 10' sind bevorzugt kleiner ausgeführt als die weiteren Partikel 21, 31, 41.

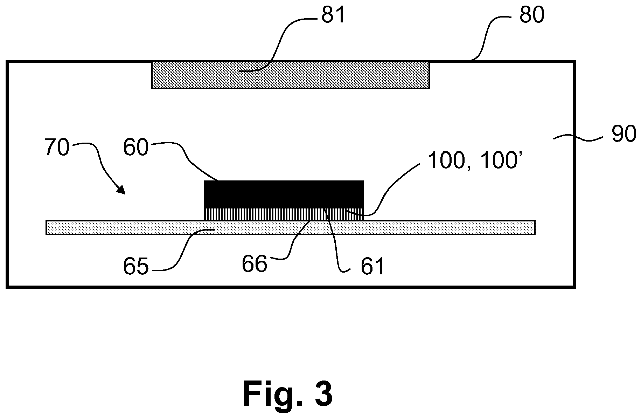

In Fig. 3 ist ein Sinterofen 80 gezeigt, sowie eine in einem Prozessraum 90 des Sinterofens 80 angeordnete elektronische Schaltung 70. Die elektronische Schaltung 70 weist ein Substrat 65 mit mindestens einer ersten Kontaktstelle 66 aus Kupfer auf. Auf dem Substrat 65 ist ein Chip 60 mit zumindest einer zweiten Kontaktstelle 61 aus einer Silberlegierung angeordnet. Zwischen der mindestens ersten Kontaktstelle 66 aus Kupfer und der zumindest zweiten Kontaktstelle 61 aus der Silberlegierung ist ein erfindungsgemäßer Ausgangswerkstoff 100 als Paste aufgetragen. Der Ausgangswerkstoff 100 enthält dabei anteilig eine Mischung von Partikeln 10, 21 bzw. 10, 31 entsprechend den Fig. 2a und 2b.

Zur Ausbildung einer Sinterverbindung 100' zwischen der mindestens ersten Kontaktstelle 66 des Substrates 65 und der zumindest zweiten Kontaktstelle 61 des Chips 60, wird die elektronische Schaltung 70 mit dem enthaltenen Ausgangswerkstoff 100 einer Temperaturbehandlung unterzogen. Zur Durchführung der Temperaturbehandlung enthält der Sinterofen 80 innerhalb des Prozessraumes 90 eine Heizvorrichtung 81. Im Prozessraum 90 liegt während der Temperaturbehandlung des Ausgangswerkstoffes 100 beispielsweise ein Vakuum oder eine Schutzgasatmosphäre vor.

Infolge der Temperaturbehandlung der elektronischen Schaltung 70 werden im Ausgangswerkstoff 100 chemische Reaktionsprozesse ausgelöst. So wird mittels der Fettsäure der zweiten Beschichtung 12 der im Ausgangswerkstoff 100 enthaltenen Partikeln 10, ein Reduktionsprozess gestartet. Dabei wirkt die Fettsäure 12 als Reduktionsmittel, welche die in den Partikel 10 innerhalb der ersten Beschichtung 11 enthaltene organische Metallverbindung 11 aus Ag₂CO₃, Ag₂O und/oder AgO zu elementarem Silber reduziert. Diese Reduktion erfolgt bereits bei einer Temperatur unterhalb der Sintertemperatur von Silber.

Infolge der stöchiometrischen Verteilung der Fettsäure der zweiten Beschichtung 12 zum Anteil der in der ersten Beschichtung 11 der Partikel 10 enthaltenen organischen Metallverbindung aus Ag₂CO₃, Ag₂O oder AgO, erfolgt eine weitestgehend vollständige Umwandlung der ersten Beschichtung 11 in Silber. Zusätzlich verbleiben weitestgehend keine Reste an Fettsäure in der gebildeten Sinterverbindung 100', die ansonsten bei einem verbleibenden Rest von <1% unter Sauerstoffzufuhr ausgebrannt werden müssten.
Der metallische Kern 13 der Partikel 10 versintert mit der auf dem Kern 13 angeordneten und nun in Silber umgewandelten ersten Beschichtung 11 und bildet eine Silbermatrix als einen Teil des Sintergefüges der sich bildenden Sinterverbindung 100' aus. Ebenso erfolgt mittels der gebildeten Sinterverbindung 100' eine Kontaktierung der ersten und zweiten Kontaktstelle 61, 66 des Substrates bzw. des Chips 65. Eine Kontaktierung der ersten Kontaktstelle 66 aus Kupfer während der Temperaturbehandlung ohne Korrosionserscheinungen ist möglich, da die Kontaktierung unter Vakuum oder einer Schutzgasatmosphäre erfolgt. Dadurch bleibt ein unedles Material, wie beispielsweise aus Kupfer, auch während der Temperaturbehandlung zur Ausbildung der Sinterverbindung 100' frei von Oxidationsprodukten.

Die in dem Ausgangswerkstoff 100 als Mischung mit den Partikeln 10 enthaltenen weiteren Partikel 31 aus Zinn schmelzen während der Temperaturbehandlung frühzeitig auf und unterstützen einen stofflichen Kontakt aller im Ausgangswerkstoff 100 enthaltenen Partikel 10, 21, 31. Zusätzlich bildet das Zinn der weiteren Partikel 31 Legierungen mit dem Silber der durch die Reduktion umgewandelten ersten Beschichtung 11. Diese Legierungen liegen dann als duktile Phasen innerhalb der im Sintergefüge ausgebildeten Silbermatrix vor.

Die ebenfalls als Mischung im Ausgangswerkstoff 100 enthaltenen weiteren Partikel 21 aus Silizium verhalten sich während des Sintervorgangs inert. Dabei unterstützt die auf den weiteren Partikel 21 aufgetragene Beschichtung 22 aus der Silberverbindung die Versinterung innerhalb des Sintergefüges. Die weiteren Partikel 21 aus Silizium liegen nach Ausbildung der Sinterverbindung 100' fein verteilt innerhalb der Silbermatrix des Sintergefüges vor.

## Patentansprüche

1. Ausgangswerkstoff (100) für eine Sinterverbindung (100'), umfassend Partikel (10' ), die aus einem Silbercarbonat, einem Silberlactat, einem Silberstearat, einem Natriumcarbonat und/oder aus einem Edelmetalloxid bestehen, wobei das Silbercarbonat, das Silberlactat, das Silberstearat, das Natriumcarbonat und/oder das Edelmetalloxid bei einer Temperaturbehandlung des Ausgangswerkstoffes (100) in das zugrunde liegende elementare Metall und/oder Edelmetall umgewandelt wird, wobei die Partikel (10') eine Beschichtung (12) enthaltend ein Reduktionsmittel aufweisen, wobei das Reduktionsmittel eingerichtet ist, das Silbercarbonat, das Silberlactat, das Silberstearat, das Natriumcarbonat und/oder das Edelmetalloxid zu dem elementaren Metall und/oder Edelmetall bei einer Temperatur unterhalb der Sintertemperatur des elementaren Metalls und/oder Edelmetalls zu reduzieren, und wobei das Reduktionsmittel mindesten einen Alkohol aus der Gruppe der primären oder sekundären Alkohole und/oder ein Amin und/oder eine Ameisensäure und/oder eine Fettsäure beinhaltet.

2. Ausgangswerkstoff nach Anspruch 1, **dadurch gekennzeichnet, dass** die Fettsäure eine Isostearinsäure, eine Stearinsäure, eine Ölsäure, eine Laurinsäure, oder dass es eine Mischung verschiedener Fettsäuren ist.

3. Ausgangswerkstoff nach einem der vorhergehenden Ansprüche, **dadurch gekennzeichnet, dass** das Edelmetalloxid ein Silberoxid ist.

4. Ausgangswerkstoff nach einem der vorhergehenden Ansprüche, **dadurch gekennzeichnet, dass** der Anteil des Silbercarbonats, des Silberlactats, des Silberstearats oder des Natriumcarbonats und/oder des Edelmetalloxids zum Anteil des Reduktionsmittels in der Beschichtung (12) enthaltend ein Reduktionsmittel in einem stöchiometrischen Verhältnis vorliegt.

5. Ausgangswerkstoff nach einem der vorhergehenden Ansprüche, **dadurch gekennzeichnet, dass** die Partikel (10') eine mittlere Korngröße von 0,01-50 µm aufweisen.

6. Ausgangswerkstoff nach Anspruch 5, **dadurch gekennzeichnet, dass** die Partikel (10, 10') eine mittlere Korngröße von 0,1-10 µm, aufweisen.

7. Ausgangswerkstoff nach einem der vorhergehenden Ansprüche, **dadurch gekennzeichnet, dass** zusätzlich weitere Partikel (21, 31, 41) enthaltend ein Edelmetall und/oder ein Element der vierten Hauptgruppe des Periodensystems vorgesehen sind.

8. Ausgangswerkstoff nach Anspruch 7 **dadurch gekennzeichnet, dass** die weiteren Partikel (21, 31, 41) eine Beschichtung aus einem Edelmetall oder einer organischen Beschichtung enthaltend ein Reduktionsmittel aufweisen.

9. Verwendung eines Ausgangswerkstoffes nach einem der Ansprüche 1 bis 8 in einer Sinterverbindung.

10. Verfahren zur Ausbildung einer thermisch und/oder elektrisch leitenden Sinterverbindung (100'), wobei ein Ausgangswerkstoff (100) der Sinterverbindung ( 100') nach einem der Ansprüche 1 bis 8 vorgesehen wird, umfassend folgende Schritte:
- Bereitstellen des Ausgangsstoffes (100)
- Ausbilden der Sinterverbindung (100') durch die Temperaturbehandlung des Ausgangswerkstoffes (100), wobei bei einer Temperatur unterhalb der Sintertemperatur des elementaren Metalls und/oder Edelmetalls das Silbercarbonat, das Silberlactat, das Silberstearat, das Natriumcarbonat und/oder das Edelmetalloxid mittels der Beschichtung (12) enthaltend ein Reduktionsmittel zum elementaren Metall und/oder Edelmetall reduziert werden.

11. Verfahren nach Anspruch 10, **dadurch gekennzeichnet, dass** die Sinterverbindung (100') bei einer Temperatur unterhalb 500°C ausgebildet wird.

12. Verfahren nach Anspruch 11, **dadurch gekennzeichnet, dass** die Sinterverbindung (100') bei einer Temperatur unterhalb 250°C ausgebildet wird.

13. Verfahren nach einem der Ansprüche 10 bis 12, **dadurch gekennzeichnet, dass** die Sinterverbindung (100') im Vakuum und/oder in einer Stickstoffatmosphäre ausgebildet wird.

14. Verfahren nach einem der Ansprüche 10 bis 13, **dadurch gekennzeichnet, dass** der Ausgangswerkstoff (100) in Form einer Druckpaste oder als Formteil ausgebildet wird.

## Claims

1. Starting material (100) for a sintered body (100'), which comprises particles (10') consisting of a silver carbonate, a silver lactate, a silver stearate, a sodium carbonate and/or a noble metal oxide, wherein the silver carbonate, the silver lactate, the silver stearate, the sodium carbonate and/or the noble metal oxide is converted in a thermal treatment of the starting material (100) into the parent elemental metal and/or noble metal, wherein the particles (10') have a coating (12) containing a reducing agent, wherein the reducing agent is able to reduce the silver carbonate, the silver lactate, the silver stearate, the sodium carbonate and/or the noble metal oxide to the elemental metal and/or noble metal at a temperature below the sintering temperature of the elemental metal and/or noble metal, and wherein the reducing agent comprises at least one alcohol from the group consisting of primary or secondary alcohols and/or an amine and/or a formic acid and/or a fatty acid.

2. Starting material according to Claim 1, **characterized in that** the fatty acid is an isostearic acid, a stearic acid, an oleic acid, a lauric acid or a mixture of various fatty acids.

3. Starting material according to either of the preceding claims, **characterized in that** the noble metal oxide is a silver oxide.

4. Starting material according to any of the preceding claims, **characterized in that** the proportion of the silver carbonate, the silver lactate, the silver stearate or the sodium carbonate and/or the noble metal oxide is in a stoichiometric ratio to the proportion of the reducing agent in the coating (12) containing a reducing agent.

5. Starting material according to any of the preceding claims, **characterized in that** the particles (10') have an average particle size of 0.01-50 µm.

6. Starting material according to Claim 5, **characterized in that** the particles (10, 10') have an average particle size of 0.1-10 µm.

7. Starting material according to any of the preceding claims, **characterized in that** further particles (21, 31, 41) containing a noble metal and/or an element of the fourth main group of the Periodic Table are additionally provided.

8. Starting material according to Claim 7, **characterized in that** the further particles (21, 31, 41) have a coating composed of a noble metal or an organic coating containing a reducing agent.

9. Use of a starting material according to any of Claims 1 to 8 in a sintered bond.

10. Process for forming a thermally and/or electrically conductive sintered bond (100'), where a starting material (100) of the sintered bond (100') according to any of Claims 1 to 8 is provided, which comprises the following steps:
- provision of the starting material (100),
- formation of the sintered bond (100') by thermal treatment of the starting material (100), where the silver carbonate, the silver lactate, the silver stearate, the sodium carbonate and/or the noble metal oxide are reduced to the elemental metal and/or noble metal by means of the coating (12) containing a reducing agent at a temperature below the sintering temperature of the elemental metal and/or noble metal.

11. Process according to Claim 10, **characterized in that** the sintered bond (100') is formed at a temperature below 500°C.

12. Process according to Claim 11, **characterized in that** the sintered bond (100') is formed at a temperature below 250°C.

13. Process according to any of Claims 10 to 12, **characterized in that** the sintered bond (100') is formed under reduced pressure or in a nitrogen atmosphere.

14. Process according to any of Claims 10 to 13, **characterized in that** the starting material (100) is in the form of a printing paste or in the form of a shaped part.

## Revendications

1. Matériau de départ (100) pour un composé fritté (100'), comprenant des particules (10'), qui sont constituées d'un carbonate d'argent, d'un lactate d'argent, d'un stéarate d'argent, d'un carbonate de sodium et/ou d'un oxyde de métal noble, le carbonate d'argent, le lactate d'argent, le stéarate d'argent, le carbonate de sodium et/ou l'oxyde de métal noble, lors d'un traitement de température du matériau de départ (100) étant convertis en métal et/ou en métal noble élémentaires sous-jacents, les particules (10') présentant un revêtement (12) contenant un agent de réduction, l'agent de réduction étant mis en place pour réduire le carbonate d'argent, le lactate d'argent, le stéarate d'argent, le carbonate de sodium et/ou l'oxyde de métal noble en métal et/ou en métal noble élémentaires à une température inférieure à la température de frittage du métal et/ou du métal noble élémentaires, et l'agent de réduction contenant au moins un alcool du groupe des alcools primaires ou secondaires et/ou une amine et/ou un acide formique et/ou un acide gras.

2. Matériau de départ selon la revendication 1, **caractérisé en ce que** l'acide gras est un acide isostéarique, un acide stéarique, un acide oléique, un acide laurique, ou **en ce qu'**il s'agit d'un mélange de différents acides gras.

3. Matériau de départ selon l'une quelconque des revendications précédentes, **caractérisé en ce que** l'oxyde de métal noble est un oxyde d'argent.

4. Matériau de départ selon l'une quelconque des revendications précédentes, **caractérisé en ce que** la proportion du carbonate d'argent, du lactate d'argent, du stéarate d'argent ou du carbonate de sodium et/ou de l'oxyde de métal noble par rapport à la proportion de l'agent de réduction dans le revêtement (12) contenant un agent de réduction est présente en un rapport stœchiométrique.

5. Matériau de départ selon l'une quelconque des revendications précédentes, **caractérisé en ce que** les particules (10') présentent une granulométrie moyenne de 0,01 à 50 µm.

6. Matériau de départ selon la revendication 5, **caractérisé en ce que** les particules (10, 10') présentent une granulométrie moyenne de 0,1 à 10 µm.

7. Matériau de départ selon l'une quelconque des revendications précédentes, **caractérisé en ce qu'**en plus, des particules supplémentaires (21, 31, 41) contenant un métal noble et/ou un élément du quatrième groupe principal du système périodique sont prévues.

8. Matériau de départ selon la revendication 7, **caractérisé en ce que** les particules supplémentaires (21, 31, 41) présentent un revêtement composé d'un métal noble ou un revêtement organique contenant un agent de réduction.

9. Utilisation du matériau de départ selon l'une quelconque des revendications 1 à 8 dans un composé fritté.

10. Procédé pour la formation d'un composé fritté (100') conducteur thermiquement et/ou électriquement, un matériau de départ (100) du composé fritté (100') selon l'une quelconque des revendications 1 à 8 étant prévu, comprenant les étapes suivantes :
- mise à disposition du matériau de départ (100)
- formation du composé fritté (100') par le traitement de température du matériau de départ (100), où à une température inférieure à la température de frittage du métal et/ou du métal noble élémentaires, le carbonate d'argent, le lactate d'argent, le stéarate d'argent, le carbonate de sodium et/ou l'oxyde de métal noble sont réduits en métal et/ou en métal noble élémentaires au moyen du revêtement (12) contenant un agent de réduction.

11. Procédé selon la revendication 10, **caractérisé en ce que** le composé fritté (100') est formé à une température inférieure à 500 °C.

12. Procédé selon la revendication 11, **caractérisé en ce que** le composé fritté (100') est formé à une température inférieure à 250 °C.

13. Procédé selon l'une quelconque des revendications 10 à 12, **caractérisé en ce que** le composé fritté (100') est formé sous vide et/ou dans une atmosphère d'azote.

14. Procédé selon l'une quelconque des revendications 10 à 13, **caractérisé en ce que** le matériau de départ (100) est formé sous forme d'une pâte d'impression ou en tant que pièce moulée.
